(19) Europäisches Patentamt

European Patent Office

Office européen des brevets

(11) **EP 1 499 012 B1**

(12) **EUROPÄISCHE PATENTSCHRIFT**

(45) Veröffentlichungstag und Bekanntmachung des Hinweises auf die Patenterteilung:
**06.09.2006  Patentblatt 2006/36**

(51) Int Cl.:
***H03F 1/32*** *(2006.01)*

(21) Anmeldenummer: **03016253.1**

(22) Anmeldetag: **17.07.2003**

(54) **Verfahren und Schaltungsanordnung zur Linearisierung eines Leistungsverstärkers in Mobilfunktelefonen**

Method and apparatus for linearization of a power amplifier for mobile phones

Procédé et dispositif de linéarisation d'un amplificateur des téléphones mobiles

(84) Benannte Vertragsstaaten:
**DE FR GB**

(43) Veröffentlichungstag der Anmeldung:
**19.01.2005  Patentblatt 2005/03**

(73) Patentinhaber: **BenQ Corporation**
**Gueishan**
**Taoyuan 333 (TW)**

(72) Erfinder: **Langer, Andreas**
**85716 Unterschleissheim-Lohhof (DE)**

(74) Vertreter: **Epping - Hermann - Fischer**
**Patentanwaltsgesellschaft mbH**
**Ridlerstrasse 55**
**80339 München (DE)**

(56) Entgegenhaltungen:
**EP-A- 1 280 272          WO-A-98/28888**
**US-A- 5 910 965**

- **ANTONIO F ET AL: "A novel adaptive predistortion technique for power amplifiers" , VEHICULAR TECHNOLOGY CONFERENCE, 1999 IEEE 49TH HOUSTON, TX, USA 16-20 MAY 1999, PISCATAWAY, NJ, USA, IEEE, US, PAGE(S) 1505-1509 XP010342098 ISBN: 0-7803-5565-2 * das ganze Dokument ***
- **GAO X Y ET AL: "Adaptive linearization schemes for weakly nonlinear systems using adaptive linear and nonlinear FIR filters" , CIRCUITS AND SYSTEMS, 1990., PROCEEDINGS OF THE 33RD MIDWEST SYMPOSIUM ON CALGARY, ALTA., CANADA 12-14 AUG. 1990, NEW YORK, NY, USA, IEEE, US, PAGE(S) 9-12 XP010047763 ISBN: 0-7803-0081-5 * das ganze Dokument ***

**Beschreibung**

Die Erfindung betrifft ein Verfahren und eine Schaltungsanordnung zur Linearisierung eines Leistungsverstärkers in Mobilfunktelefonen, vorzugsweise eines UMTS-Leistungsverstärkers, bei dem/der amplituden- und phasenmodulierte Signale eines digitalen Basisbandes vorverzerrt (Digitale Basisband Predistortion), dann am Eingang des nichtlinearen Leistungsverstärkers eingespeist und als verstärkte Signale am Ausgang des Leistungsverstärkers ausgekoppelt und abgetastet werden, wobei durch einen Signalvergleich Vorverzerrungsfaktoren bestimmt werden, die vorzugsweise in einer Look-Up-Tabelle hinterlegt werden.

In vielen Bereichen, wie beispielsweise auch bei Multimode-Mobiltelefonen, wird eine lineare Signalverstärkung benötigt. Eine Möglichkeit eine lineare Signalverstärkung zu erreichen, besteht darin, einen nichtlinearen Leistungsverstärker, der also eine nichtlineare Kennlinie aufweist, durch Einspeisung eines vorverzerrten Signals zu linearisieren. Dieses Verstärkungsverfahren wird Predistortion (Vorverzerrung) genannt. Durch die Kombination des vorverzerrten eingespeisten Signals und der nichtlinearen Verstärkerkennlinie ergibt sich insgesamt eine lineare Kennlinie des Leistungsverstärkers und somit eine lineare Signalverstärkung.

Auch HPSK (= Hybrid Phase Shift Keying) bei UMTS (= Universal Mobile Telecommunications System) benötigt einen linearen beziehungsweise linearisierten Leistungsverstärker, um nichtlineare Verzerrungen der Einhüllenden des Signals zu verhindern.

Solche nichtlinearen Verzerrungen führen zu einer Erhöhung der Nachbarkanalleistung, auch spectral regrowth genannt. Diese Erhöhung ist jedoch unerwünscht, da dadurch andere Mobilfunkteilnehmer gestört werden können. Für die maximale Nachbarkanalleistung existieren in den Mobilfunkstandards genau definierte Anforderungen, zum Beispiel ACLR bei UMTS, deren Erfüllung auf der Senderseite oftmals mit einem signifikanten Aufwand verbunden ist.

Es ist daher Aufgabe der Erfindung, ein verbessertes Verfahren und eine verbesserte Schaltungsanordnung zur Linearisierung einer Kennlinie eines Leistungsverstärkers in Mobilfunktelefonen, vorzugsweise eines UMTS-Leistungsverstärkers, vorzustellen, wobei durch das Verfahren und die Schaltungsanordnung nichtlineare Verzerrungen reduziert werden.

Diese Aufgabe wird durch die Merkmale des unabhängigen Patentanspruches 1 und den Vorrichtungsanspruch 6 gelöst. Vorteilhafte Weiterbildungen der Erfindung sind Gegenstand untergeordneter Patentansprüche.

Der Erfinder hat erkannt, dass es möglich ist, bei Linearisierungsverfahren, nichtlineare Verzerrungen zu reduzieren und gleichzeitig die beim Signalvergleich auftretenden Zeitverzögerungen zu vermeiden, wenn das am Signaleingang des Leistungsverstärkers eingespeiste Signal am Signalausgang des Leistungsverstärkers ausgekoppelt, dann das eingespeiste Signal regeneriert wird und anschließend im ausgekoppelten Teil ein Signalvergleich stattfindet.

Aus EP1280272 ist ein Mobilfunksystem bekannt, in dem die Vorverzerrungsfaktoren für den Sender nicht lokal, sondern in einem entfernten Empfänger berechnet und an den Sender über Funk zurückgesendet werden. Der Empfänger berechnet die Vorverzerrungsfaktoren allein auf Basis des empfangenen Signals und eines davon abgeleiteten Referenzsignals; dadurch wird das Zeitverzögerungsproblem vermieden. WO98/28888 offenbart ein ähnliches System.

Entsprechend dem allgemeinen Erfindungsgedanken schlägt der Erfinder ein Verfahren zur Linearisierung eines Leistungsverstärkers in Mobilfunktelefonen, vorzugsweise eines UMTS-Leistungsverstärkers, bei dem amplituden- und phasenmodulierte Signale eines digitalen Basisbandes vorverzerrt (Digitale Basisband Predistortion), anschließend am Eingang des nichtlinearen Leistungsverstärkers eingespeist und als verstärkte Signale am Ausgang des Leistungsverstärkers ausgekoppelt und abgetastet werden, wobei durch einen Signalvergleich Vorverzerrungsfaktoren bestimmt werden, wobei das Verfahren dadurch gekennzeichnet ist, dass zum Signalvergleich die am Ausgang ausgekoppelten und abgetasteten Signale in zwei Teile verzweigt werden, wobei in einem ersten Teil die Signale des Basisbandes regeneriert werden und ein zweiter Teil unverändert bleibt und der erste Teil mit dem zweiten Teil verglichen wird.

Hierdurch wird im ersten abgespaltenen Teil ein Signal mit dem richtigen zeitlichen Bezug generiert. Die Generierung oder besser Regenerierung des Signals erfolgt analog der Vorgehensweise im eigentlichen Empfänger. Für diese Signalregenerierung wird der erste Teil demoduliert und danach gefaltet. Die Faltung des Signals wird mit dem für den jeweiligen Mobilfunkstandard gültigen Sendefilter realisiert.

Durch die Regenerierung des Signals aus dem ausgekoppelten Signal wird das eingekoppelte Signal regeneriert, wobei alle Verzögerungen darin enthalten sind. Beim Signalvergleich ist es nun nicht mehr notwendig, eine aufwendig zu implementierende Delay Time Estimation anzuwenden.

Für das Verfahren ist es vorteilhaft, wenn die Kennlinie des Leistungsverstärkers in Bezug auf AM/AM- und AM/PM-Konversion durch Polynome modelliert wird und in Abhängigkeit des Signalvergleichs die Koeffizienten der Polynome errechnet werden.

Hierdurch kann die Kennlinie des Leistungsverstärkers besonders schnell bei sich ändernder Umgebungsbedingung durch ein einfaches mathematisches Verfahren approximiert werden.

Es ist außerdem günstig, die Vorverzerrungsfaktoren aus den Polynomen mit den Polynomkoeffizienten zu errechnen. Ein möglicher mathematischer Ansatz wird durch die Gleichung 13 in der Figurenbeschreibung eröffnet.

Hierdurch können die Vorverzerrungsfaktoren, die zum Beispiel in einer Look-Up-Tabelle stehen können, schnell angepasst werden.

Entsprechend dem neuen Verfahren zur Linearisierung eines Leistungsverstärkers schlägt der Erfinder auch vor, eine Schaltungsanordnung zur Linearisierung eines Leistungsverstärkers in Mobilfunktelefonen, vorzugsweise eines UMTS-Leistungsverstärkers, mindestens bestehend aus: einem Leistungsverstärker, an dessen Signaleingang phasen- und amplitudenmodulierte Signale eines Basisbandes mit einer Vorverzerrereinheit eingespeist werden, die am Signalausgang als verstärkte Signale für einen Empfänger ausgeben werden und einem Koppler, der die Signale am Signalausgang auskoppelt und mit einem Analog/Digital-Wandler abtastet, wobei durch einen Signalvergleich Vorverzerrungsfaktoren bestimmt werden, dahingehend zu verbessern, dass zum Signalvergleich die am Ausgang ausgekoppelten und abgetasteten Signale mit einem Verzweiger in zwei Teile verzweigt werden, wobei in einem erster Teil eine Regenerierung der Signale des Basisbandes stattfindet und ein zweiter Teil unverändert bleibt und Mittel angeordnet sind, die den ersten Teil mit dem zweiten Teil vergleichen.

Hierdurch wird im ersten abgespaltenen Teil ein Signal mit dem richtigen zeitlichen Bezug generiert. Die Regenerierung des Signals erfolgt analog der Vorgehensweise im eigentlichen Empfänger. Hierzu können beispielsweise ein Demodulator und ein Filter, vorzugsweise der für den Mobilfunkstandard gültigen Sendefilter, verwendet werden. Durch die Regenerierung des Signals aus dem ausgekoppelten Signal und der anschließenden Faltung mit dem Sendefilter wird das Basisbandsignal wieder regeneriert, wobei alle Verzögerungen darin enthalten sind. Beim Signalvergleich ist es nun nicht mehr notwendig, eine aufwendig zu implementierende Delay Time Estimation anzuwenden.

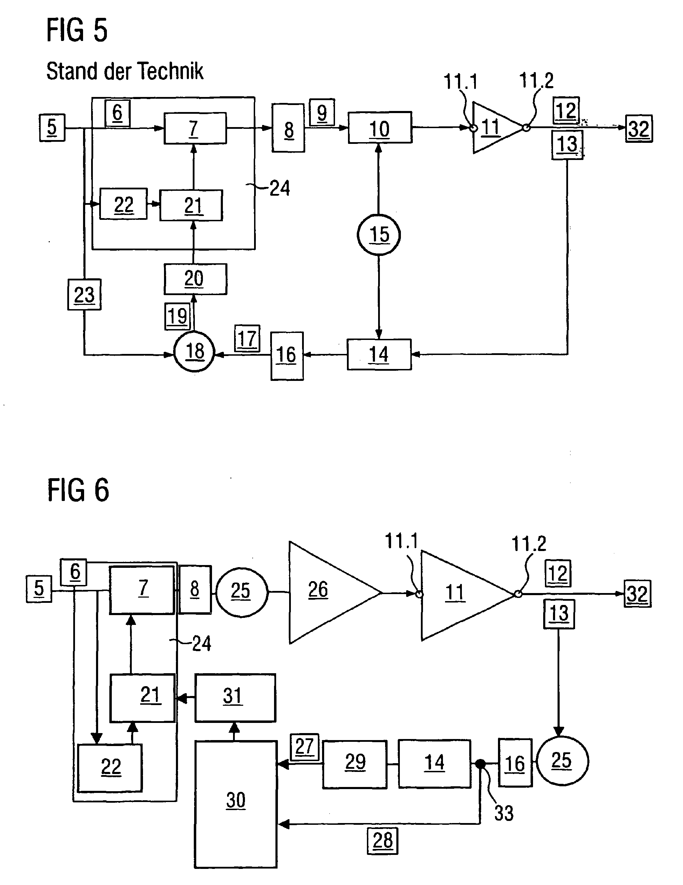

In der Schaltungsanordnung sollten Mittel angeordnet sein, die die Kennlinie des Leistungsverstärkers in Bezug auf dessen AM/AM und AM/PM-Charakteristik durch Polynome modellieren. Dies wird beispielsweise im Block Parameter Extraktion in Figur 6 realisiert. Im Block Parameter Extraktion werden durch mathematische Operationen, die Koeffizienten der den Leistungsverstärker charakterisierenden Polynome bestimmt.

Mit Hilfe dieser charakterisierenden Polynome werden Koeffizienten, die im allgemeinen komplexe Werte haben und die von der momentanen Amplitude der komplexen Einhüllenden abhängig sind, berechnet.

Diese amplitudenabhängigen Koeffizienten werden als Vorverzerrungsfaktoren in einer Look-Up-Tabelle hinterlegt. Im Betrieb des Gerätes wird die komplexe Einhüllende in Abhängigkeit ihrer momentanen Amplitude komplex mit den Vorverzerrungsfaktoren multipliziert. Die Auswahl der Vorverzerrungsfaktoren erfolgt entsprechend der momentanen Amplitude der Einhüllenden. Die Bestimmung der Vorverzerrungsfaktoren aus den charakterisierenden Polynomen ist ein Teil der Erfindung und wird im Folgenden näher erläutert.

Im Folgenden wird die Erfindung anhand eines bevorzugten Ausführungsbeispiels mit Hilfe der Figuren beschrieben, wobei in den Figuren die folgenden Abkürzungen verwendet werden: 1: Signal V; 2: Vorverzerrer mit Charakteristik G(V); 3: Leistungsverstärker PA mit Kennlinie H(x); 4: Signal V, um den Faktor k verstärkt; 5: Basisband; 6: Signal $V_m(t)$ aus dem Basisband; 7: Komplexer Multiplizierer; 8: Digital/Analog Wandler; 9: Signal $V_d(t)$ vor der Modulation; 10: Modulator; 11: Leistungsverstärker; 11.1: Signaleingang des Leistungsverstärkers; 11.2: Signalausgang des Leistungsverstärkers; 12: Sendesignal $V_a(t)$ des Leistungsverstärkers; 13: Koppler; 14: Demodulator; 15: Local Oszilator; 16: Analog/Digital Wandler; 17: Ausgangssignal $V_f(t)$ nach Demodulation und Quantisierung; 18: Vergleichereinheit; 19: Differenzsignal $V_e(t)$; 20: Aktualisierung und Anpassung der Algorithmen; 21: Look-Up-Tabelle; 22: Eingangsamplitude des Signals $V_m(t)$ = Betrag des Signals im Quadrat = $|V_m(t)|^2$; 23: Zeitverzögerung $\tau_D$; 24: Vorverzerrereinheit/Predistorer; 25: Mischer; 26: Vorverstärker Variable Gain Amplifier VGA; 27: Ausgangssignal $V_{reg}(t)$ nach Quantisierung, Demodulation und Faltung; 28: Ausgangssignal $V_{ab}(t)$ nach der Quantisierung; 29: Sendefilter; 30: Parameter Extraktion; 31: Berechnung der Look-Up-Tabelle; 32: Empfänger; 33: Verzweiger.

Die Figuren zeigen im Einzelnen:

Figuren 1 bis 3: Diagramme, in denen die Ausgangsleistung gegen die Eingangsleistung, die Phase bei AM/AP-Konversion und die Verstärkung bei AM/AM-Konversion eines 1,92 Gigahertz Leistungsverstärkers aufgetragen ist;

Figur 4: Prinzipskizze zur Wirkungsweise der digitalen Basisband Predistortion;

Figur 5: Bekannte Schaltungsanordnung zur Durchführung einer digitalen Basisband Predistortion;

Figur 6: Schaltungsanordnung zur Durchführung des erfindungsgemäßen Linearisierungsverfahren.

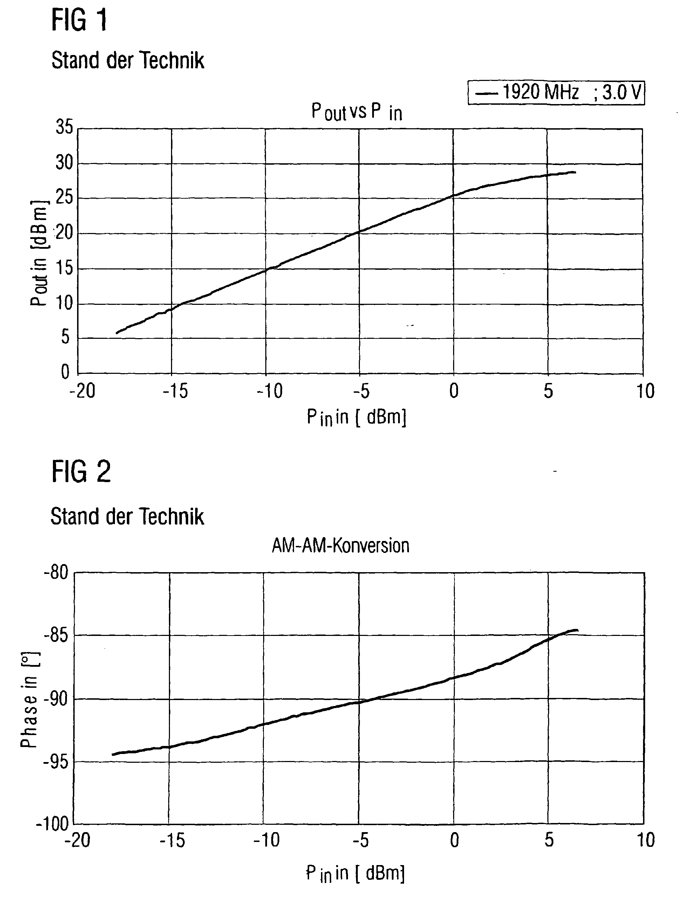

Die Figuren 1 bis 3 zeigen Diagramme, in denen verschiedene Messkurven eines Leistungsverstärkers aufgetragen sind. Bei diesem Leistungsverstärker handelt es sich um einen UMTS-Leistungsverstärker, der eine Sendefrequenz von 1,92 Gigahertz aufweist, wobei ein Gigahertz $10^9$ Hertz [1 Hz = 1/Sekunde] entspricht.

Im Diagramm der Figur 1 wird die Ausgangsleistung $P_{out}$ gegenüber der Eingangsleistung $P_{in}$ dieses Leistungsverstärkers jeweils in dBm aufgetragen. Wobei ein dBm, die mit dem Faktor 10 multiplizierte logarithmische Leistung bezogen auf ein Milliwatt Leistung, entspricht. Man erkennt, dass der Leistungsverstärker über einen Bereich der Eingangsleistung $P_{in}$ von circa -17 dBm bis circa +0 dBm eine relativ lineare Kennlinie aufweist. Das heißt die Ausgangsleistung $P_{out}$ ist proportional zur Eingangsleistung $P_{in}$. Ab einer Eingangsleistung von +0 dBm wird die Kennlinie nichtlinear.

Im Diagramm der Figur 2 wird die AM/PM-Konversion des Leistungsverstärkers dargestellt, in dem die Phase des Ausgangssignals des Leistungsverstärkers in Grad gegenüber der Eingangsleistung $P_{in}$ in dBm aufgetragen ist. Im Bereich der Eingangsleistung von circa -17 dBm bis circa +5 dBm ist die Phase zwischen circa -95 Grad und circa -85 Grad und weicht von der idealen Kompression eines Leistungsverstärkers ab.

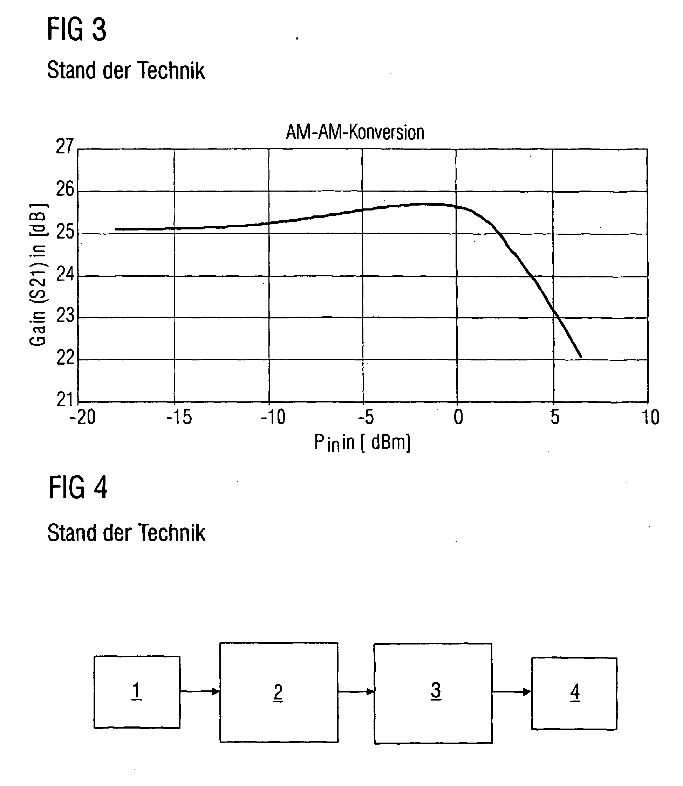

Im Diagramm der Figur 3 wird die AM/AM-Konversion dieses Leistungsverstärkers dargestellt, in dem die Verstärkung Gain in dB gegenüber der Eingangsleistung $P_{in}$ in dBm aufgetragen ist.

Vorallem im Diagramm der Figur 3 ist zu erkennen, das die Verstärkung in einem Bereich der Eingangsleistung $P_{in}$ zwischen circa -17 dBm bis circa -10 dBm nahezu gleichbleibend ist. Diese gleichbleibende Leistung ist bei einem Leistungsverstärker auch erwünscht. Ab einer Eingangsleistung größer circa -10 dBm wird der nichtlineare Charakter des Leistungsverstärkers sichtbar, indem die Verstärkung bis auf einen Maximalwert leicht ansteigt und dann abfällt.

Das nichtlineare Verhalten eines Leistungsverstärkers wird üblicherweise mathematisch durch eine Potenzreihe angenähert. Eine solche Potenzreihe kann beispielsweise die Form folgender Gleichung haben:

$$y(t) = ax(t) + cx^3(t) + \ldots \qquad \text{(Gleichung 1)}$$

Dieser Potenzreihenansatz ist relativ weit verbreitet, hat aber nur eine Gültigkeit bei der Nichtlinearität von Leistungsverstärkern ohne Memory-Effekt. Über die Gleichung 1 kann die AM/AM-Konversion, aber nicht die AM/PM-Konversion beschrieben werden. Die Beschreibung der AM/PM-Konversion wird möglich, sobald die Koeffizienten (c in Gleichung 1) der nichtlinearen Glieder ($x^3(t)$ in Gleichung 1) komplex sind. Werden die Koeffizienten der nichtlinearen Glieder komplex geschrieben, ergibt sich dann folgende Potenzreihe:

$$y(t) = ax(t) + ce^{j\varphi}x^3(t) + \ldots \qquad \text{(Gleichung 2)}$$

Dabei ist der Winkel $\varphi$ bei einem komprimierenden Verstärker ohne AM/PM-Konversion -180 Grad. Weicht der Winkel von -180 Grad ab, so tritt AM/PM-Konversion auf.

Die Linearität eines Leistungsverstärkers kann durch den Einsatz von speziellen Linearisierungsverfahren verbessert werden. Grundsätzlich unterscheidet man zwischen Feedback-, Feedforward- und Predistortionsverfahren. Bekannte Feedbackverfahren sind Cartesian-Feedback und Polar-Loop. Bei Predistortion (Vorverzerrung) wiederum unterscheidet man zwischen RF-Predistortion und digitaler Basisband Vorverzerrung (= Digital Baseband Predistortion).

Im folgenden wird nun kurz die Wirkungsweise der digitalen Basisband Predistortion erläutert. "Predistortion" bedeutet dabei, dass das Eingangssignal des Verstärkers vorverzerrt wird, das heißt die Schaltungsanordnung zur Linearisierung bildet die inverse Übertragungsfunktion des Verstärkers nach, so dass die Kette bestehend aus Linearisierer und Leistungsverstärker das Signal linear verstärkt.

"Digital" besagt, dass die Verzerrung im Basisband erfolgt. Bei RF-Predistortion dagegen wird die Verzerrung in der HF-Ebene durchgeführt.

Berechnet man für einen Verstärker, der gemäß der Gleichung 2 modelliert wird, die Vorverzerrerkennlinie, so wird diese durch eine unendliche Reihe beschrieben, obwohl der Verstärker in diesem Fall nur dritter Ordnung ist. Bei "schwacher" Kompression lässt sich jedoch folgende Näherung herleiten:

$$y_P(t) = x(t) = a_p x_e(t) + c_p \, x_e^3(t) + \ldots \qquad \text{(Gleichung 3)}$$

$$a_p = \frac{G_{lin}}{a} \qquad \text{(Gleichung 4)}$$

$$c_p = -\frac{G_{lin}^3 c\, e^{j\varphi}}{a^4} \qquad \text{(Gleichung 5)}$$

wobei:

$y_p(t)$ das Ausgangssignal des Vorverzerrers ist. Dies entspricht dem Eingangssignal des Verstärkers, siehe Gleichung 2.

und

$a_p$ und $c_p$ die zugehörigen Koeffizienten sind.

$G_{lin}$ ist die lineare Verstärkung des Vorverzerrers und des Leistungsverstärkers.

Die Vorverzerrercharakteristik ist somit direkt von der Kennlinie des Leistungsverstärkers abhängig. Soll der Vorverzerrer daher in einem Mobilfunkgerät eingesetzt werden, so muss die Vorverzerrercharakteristik, in diesem Fall $a_p$ und $c_p$, immer dann angepasst werden, wenn sich infolge von Änderungen der Temperatur, Frequenz oder Versorgungsspannung die Kennlinie des Leistungsverstärkers ändert.

Die Figur 4 zeigt eine Prinzipskizze zur Wirkungsweise der digitalen Basisband Vorverzerrung. Ein Signal V 1, dass verstärkt werden soll, wird in den Vorverzerrer 2 eingespeist. Der Vorverzerrer 2 hat eine Charakteristik G(V). G(V) ist die inverse Übertragungsfunktion des Leistungsverstärkers 3. Der Vorverzerrer 2 speist das vorverzerrte Signal in den Leistungsverstärker 3 ein. Der Leistungsverstärker 3 hat eine Kennlinie H(x). Mathematisch gesehen ergibt sich nun bei Einspeisung eines vorverzerrten Signals in den Verstärker folgendes:

$$H[G(V)] = k \cdot V \qquad\qquad\qquad \text{(Gleichung 6)}$$

Das Signal V 1 wird also um den Faktor k verstärkt.

Die Figur 5 zeigt eine bekannte Schaltungsanordnung zur Durchführung einer digitalen Basisband Predistortion. Ein Signal $V_m(t)$ 6 aus dem Basisband 5 soll durch den Verstärker 11 verstärkt werden. In Abhängigkeit von der Eingangsamplitude $|V_m(t)|^2$ 22 des Signals 6 wird aus einer Look-Up-Tabelle 21 ein Wert ausgelesen. Dieser Wert, auch Vorverzerrungsfaktor genannt, der Look-Up-Tabelle 21 wird mittels dem komplexen Multiplizierer 7 mit dem Signal Vm(t) 6 komplex multipliziert. Hierdurch wird das Signal Vm(t) 6 in Betrag und Phase in der Vorverzerrereinheit/Predistorter 24 vorverzerrt. Das vorverzerrte Signal wird mit einem Digital/Analog Wandler 8 umgewandelt, dann mit einem Modulator 10 moduliert und in den Signaleingang 11.1 des Leistungsverstärkers 11 eingespeist. Am Signalausgang 11.2 des Leistungsverstärkers 11 wird das Sendesignal $V_a(t)$ 12 ausgegeben.

Die Vorverzerrungsfaktoren der Look-Up-Tabelle 21 müssen aufgrund von Änderung der Eingangsleistung und sich ändernden Umgebungsparametern des Leistungsverstärkers 11, wie zum Beispiel der Temperatur oder der Versorgungsspannung, aktualisiert und angepasst werden. Zur Aktualisierung dieser Werte wird in dieser Schaltungsanordnung das Sendesignal $V_a(t)$ 12 mit einem Koppler 13 am Signalausgang 11.2 des Leistungsverstärkers 11 ausgekoppelt. Danach wird das Signal $V_a(t)$ mit einem Demodulator 14 demoduliert, durch einen Analog/Digital Wandler 16 umgewandelt. Das demodulierte und quantisierte Signal $V_f(t)$ 17 wird durch eine Vergleichereinheit 18 mit dem Signal Vm(t) 6 des Basisbandes 5 verglichen. Das aus diesem Vergleich resultierende Differenzsignal $V_e(t)$ 19 wird dazu verwendet, um mittels eines bestimmten Algorithmus die Koeffizienten der Look-Up-Tabelle 21 zu adaptieren.

Das Problem an dieser Schaltungsanordnung zur Linearisierung eines Leistungsverstärkers mit Hilfe von digitaler Basisband Vorverzerrung ist, dass beim Signalvergleich zwischen dem Signal Vm(t) 6 und dem Signal $V_f(t)$ 17 abhängig von Bandbreite und Modulationsverfahren nur eine Zeitverzögerung $\tau_D$ 23 im Bereich von wenigen Nanosekunden tolerierbar ist, wobei eine Nanosekunde $10^{-9}$ Sekunden entspricht, sonst sind unerwünschte Effekte wie starke Erhöhung der Nachbarkanalleistung beobachtbar. Diese Zeitverzögerung $\tau_D$ 23 ist abhängig von Umgebungsparametern, wie zum Beispiel der Temperatur der Versorgungsspannung und der Frequenz des Leistungsverstärkers 11.

Gerade diese Zeitverzögerung $\tau_D$ 23 ist bei einigen Systemen und Standards unerwünscht. So soll beispielsweise bei WCDMA (= Wideband Code Division Multiplex Access) die Zeitverzögerung kleiner als vier Nanosekunden betragen.

Um diese Zeitverzögerung zu kompensieren wird in bisherigen Schaltungsanordnungen eine Delay Time Estimation, mit der die Zeitverzögerung bestimmt wird, verwendet. Die Delay Time Estimation ist nicht in der Schaltungsanordnung aus Figur 5 dargestellt. Diese Time Delay Estimation ist jedoch aufwendig zu implementieren.

Die Figur 6 zeigt eine neue Schaltungsanordnung zur Erläuterung des erfindungsgemäßen Linearisierungsverfahrens. Hierbei treten beim Signalvergleich keine Zeitverzögerungen mehr auf.

Das Sendesignal $V_a(t)$ 12 am Signalausgang 11.2 des Leistungsverstärkers 11 wird mit einem Koppler 13 ausgekoppelt und dann mit einem Mischer 25 ins Basisband 5 gemischt. Anschließend wird das Sendesignal $V_a(t)$ 12 mit einem Analog/Digital Wandler 16 umgewandelt und mit einem Verzweiger 33 aufgespalten. Ein Teil wird mit einem Demodulator 14 demoduliert. Im Gegensatz zu der Realisierung gemäß Figur 5 wird hier zusätzlich die Datenfolge wieder regeneriert. Die Demodulation erfolgt dabei analog der Vorgehensweise im eigentlichen Empfänger 32, das heißt die notwendigen Algorithmen sind bekannt. Nachdem die Datenfolge (Bitsequenz) wieder aus dem Sendesignal $V_a(t)$ 12 gewonnen wurden, wird diese mit einem Sendefilter 29, zum Beispiel einem RRC bei UMTS, gefaltet. Das quantisierte, demodulierte und gefaltete Signal $V_{reg}(t)$ 27 wird dann mit dem zweiten Teil, dem Signal $V_{ab}(t)$ nach der Quantisierung 28 verglichen. Diese Vorgehensweise ist unterschiedlich zu bekannten Predistortion Ansätzen, wo das abgetastete Signal mit dem Signal $V_m(t)$ 6 verglichen wird.

Um diesen Vorteil zu verstehen, muss berücksichtigt werden, dass beispielsweise bei UMTS die Verzögerung zwischen dem abgetasteten Signal $V_{ab}(t)$ 28 und dem Signal $V_m(t)$ 6 kleiner als vier Nanosekunden sein muss. Diese extrem hohe Genauigkeit erforderte bisher eine spezielle Delay Time Estimation, die in der Praxis sehr aufwendig ist und ständig wiederholt werden muss.

Durch die Regeneration der Datenfolge aus dem eigenen Sendesignal $V_a(t)$ 12 und anschließenden Faltung mit dem Sendefilter 29 hingegen ist das Signal $V_m(t)$ 6 des Basisbandes 5 aus dem Sendesignal $V_a(t)$ 12 generiert worden und beinhaltet somit alle Verzögerungen, hervorgerufen durch den Modulator, den Vorverstärker 26, den Leistungsverstärker 11 usw.. Man hat so das Basisbandsignal mit dem richtigen Zeitbezug generiert, das verglichen mit dem Signal $V_m(t)$ 6 um die Delay Time verschoben ist.

In dem nächsten Schritt wird das Signal $V_{reg}(t)$ 27 am Ausgang des Sendefilters 29 mit dem Signal $V_{ab}(t)$ 28 verglichen und daraus ein Modell für den Leistungsverstärker 11 generiert. Eine Zeitverzögerung beziehungsweise eine Delay Time zwischen den zu vergleichenden Signalen $V_{reg}(t)$ 27 und dem abgetasteten Signal $V_{ab}(t)$ 28 tritt bei diesem Vergleich jetzt nicht mehr auf. Der Vergleich wird im Block Parameter Extraktion 30 durchgeführt.

Die AM/AM- und AM/PM-Konversion des Leistungsverstärkers 11 wird dabei durch eine mathematische Reihe angenähert.

$V_{reg}(t)$ ist die komplexe Einhüllende des amplituden- und phasenmodulierten Signals, x(t) sei der Betrag der komplexen Einhüllenden von $V_{reg}(t)$. $V_{ab}(t)$ ist die komplexe Einhüllende des Sendesignals $v_a(t)$ 12 des Leistungsverstärkers 11, wobei $y_{AM/AM}(t)$ der Betrag der komplexen Einhüllenden ist.

Für das Ausgangssignal des Leistungsverstärkers 11 im Basisband gilt:

$$V_{ab}(t) = y_{AM/AM}(t) \exp\left[\Phi(t) + \alpha(t)\right] \qquad \text{(Gleichung 7)}$$

$\Phi(t)$ beschreibt die "gewünschte" Phasenmodulation und $\alpha(t)$ die parasitäre Phasenmodulation infolge der AM/PM-Konversion. $y_{AM/AM}(t)$ beinhaltet die Amplitudenverzerrungen infolge der AM/AM-Konversion.

Sowohl die AM/PM- als auch AM/AM-Konversion hängen nur von dem Betrag der komplexen Einhüllenden des Eingangssignals, also von x(t), ab. Diese Abhängigkeit wird jeweils durch ein Polynom approximiert:

$$y_{AM/AM}(t) = a_1 x(t) + b_1 x^2(t) + c_1 x^3(t) + \ldots \qquad \text{(Gleichung 8)}$$

$$y_{AM/PM}(t) = a_2 x(t) + b_2 x^2(t) + c_2 x^3(t) + \ldots \qquad \text{(Gleichung 9)}$$

$$V_{ab}(t) = [a_1 x(t) + b_1 x^2(t) + c_1 x^3(t)] \cdot \exp\{j\Phi(t) + j[a_2 x(t) + b_2 x^2(t) + c_2 x^3(t)]\}$$

(Gleichung 10)

Im nächsten Schritt werden die Koeffizienten für die beiden Polynome bestimmt. Dies erreicht man durch Einsetzen der Abtastwerte in die Gleichung 8 und die Gleichung 9. Bei N Abtastwerten erhält man somit N Gleichungen, die in Matrixform kompakt geschrieben werden können. Beispielhaft dargestellt ergibt sich bei Bestimmung von $a_1$, $b_1$ und $c_1$ aus Gleichung 8:

$$Y_{AM/AM} = X \otimes \begin{bmatrix} a_1 \\ b_1 \\ c_1 \end{bmatrix} \quad mit \ X = \begin{bmatrix} x_1 & x_1^2 & x_1^3 \\ x_2 & x_2^2 & x_2^3 \\ ... & ... & ... \\ x_{N-1} & x_{N-1}^2 & x_{N-1}^3 \\ x_N & x_N^2 & x_N^3 \end{bmatrix} \quad und \quad Y_{AM/AM} = \begin{bmatrix} y_{AM/AM,1} \\ y_{AM/AM,2} \\ .... \\ y_{AM/AM,N-1} \\ y_{AM/AM,N} \end{bmatrix}$$

(Gleichung 11)                         und     (Gleichung 11')

wobei:

X eine Matrix bestehend aus Abtastwerten von x(t) und der berechneten Potenzen ist.
$Y_{AM/AM}$ ist ein Vektor mit Abtastwerten, der die Antwort des Leistungsverstärkers beziehungsweise der kompletten TX-Kette auf x(t) beschreibt.

In der Regel ist die Anzahl N der Abtastwerte sehr viel größer als die Anzahl der zu bestimmenden Parameter $a_1$, $b_1$, $c_1$, .....

Das Gleichungssystem ist damit überbestimmt. Die Lösung läuft damit auf ein lineares Ausgleichsproblem hinaus. Dafür wiederum existieren effiziente Verfahren in der numerischen Mathematik, zum Beispiel die Givens-Transformation. Die mathematische Behandlung der AM/PM-Konversion erfolgt analog.

Der Output des Blockes Parameter Extraktion 30 ist somit ein Modell des Leistungsverstärkers 11 im Hinblick auf AM/AM- und AM/PM-Konversion. Basierend auf diesem Modell muss nun die Charakteristik des Vorverzerrers 24 berechnet werden. Dies ist leider mathematisch eine aufwendige Operation, welche hier nur kurz angedeutet wird.

G(V) beschreibt die Charakteristik des Vorverzerrers 24. H(x) ist die Charakteristik des Leistungsverstärkers. Somit muss gefordert werden, dass:

H[G(V)]=k·V ist,                         (Gleichung 12)

das heißt die verkettete Funktion muss proportional dem Eingangssignal des Vorverzerrers 24 sein. k ist dabei die gewünschte Verstärkung. In unserem Fall ist H(x) das Polynom, das zuvor extrahiert wurde. Wird hieraus G(V) berechnet, so erhält man wiederum ein Polynom, welches theoretisch die Ordnung Unendlich hat. Diese Darstellung ist somit ungeeignet, da in Echtzeit, je nach Genauigkeit, das heißt nach Grad des Polynoms, sehr viele Multiplikationen und Additionen durchgeführt werden müssen.

Dies kann vermieden werden, wenn aus der Polynomdarstellung eine Look-Up-Tabelle 21 berechnet wird, deren Einträge in Abhängigkeit von der momentanen Amplitude |Vm(t)| komplex mit dem Signal Vm(t) 6 des Basisbandes 5 multipliziert werden. Die hierfür notwendige Umwandlung des Polynoms in entsprechende Einträge in der Look-Up-Tabelle 21 ist ebenfalls Gegenstand der Erfindung.

Die Einträge für die Look-Up-Tabelle 21 erhält man, wenn man in der Gleichung 8 $a_1 \cdot x(t)$ ausklammert. Es ergibt sich:

$$y_{AM/AM}(t) = a_1 x(t) + b_1 x^2(t) + c_1 x^3(t) = a_1 x(t)\left[1 + \frac{b_1}{a_1}x^1(t) + \frac{c_1}{a_1}x^2(t)\right]$$

(Gleichung 13)

Der Wert in den eckigen Klammern beschreibt die Amplitudenverzerrung, hervorgerufen durch den Leistungsverstärker 11. Das Basisbandsignal Vm(t) wird nun in n Intervalle, sogenannte Amplitudenbereiche, aufgeteilt. Ein typischer Wert für n ist 64. Für die mittlere Amplitude jedes Intervalls wird der Wert in eckigen Klammern berechnet und der sich ergebene reziproke Wert, der dann mit der gewünschten Verstärkung multipliziert wird, in der Look-Up-Tabelle 21 abgespeichert. Das Polynom muss somit nur einmalig für jedes Intervall berechnet werden. Für die Phase wird eine analoge Berechnung durchgeführt, wobei in diesem Fall nur der negative Wert der berechneten Phase abgespeichert werden muss. Im späteren Betrieb ist dann nur noch eine komplexe Multiplikation notwendig. Das heißt in Abhängigkeit der momentanen Amplitude |Vm(t)| wird ein Eintrag in der Look-Up-Tabelle 21 für die Korrektur der Amplitude und Phase aus dem zugehörigen Intervall ausgewählt. Dieser Eintrag wird dann mit dem momentanen Wert des Basisbandsignals Vm(t) multipliziert. Dieser Vorgang ist ebenfalls schematisch in Figur 6 dargestellt.

Die Bestimmung der Koeffizienten und die Berechnung der Look-Up-Tabelle 31 wird immer dann durchgeführt, wenn sich die Charakteristik des Leistungsverstärkers 11 ändert. Dies passiert beispielsweise wenn sich die Frequenz, die Versorgungsspannung, die Temperatur oder die Biasspannung des Leistungsverstärkers ändern.

Die Berechnung der Look-Up-Tabelle 31 aus der Polynomdarstellung bietet den zusätzlichen Vorteil, dass bei Veränderung der VGA Verstärkung eine neue Look-Up-Tabelle 21 berechnet werden kann. In einer möglichen Realisierung muss bei Veränderung der Eingangsleistung die Look-Up-Tabelle 21 neu adaptiert werden. Speziell bei UMTS ist dies problematisch, da von der Basisstation für jeden Slot eine Erhöhung oder Erniedrigung der Ausgangsleistung gefordert werden kann, das heißt bis zu 1500 Leistungsänderungen pro Minute. Für den Vorverzerrer gilt:

$$G(V) = H^{-1}(kV) \qquad\qquad \text{(Gleichung 14)}$$

(k ist die gewünschte lineare Verstärkung)

Wird nun der Gain des VGA um den Faktor a verändert, so erhält man:

$$G^{\bullet}(V) = \frac{1}{a} H^{-1}(akV) \qquad\qquad \text{(Gleichung 14')}$$

Hat man jedoch eine Polynomdarstellung gemäß den Gleichungen 8 und 9 gewählt, so muss einfach x durch a·x (a mal x) ersetzt und die Look-Up-Tabelle 21 neu berechnet werden. In der Praxis werden hierzu mindestens zwei Tabellen benötigt. Mit der ersten Tabelle wird die Vorverzerrung durchgeführt. Die zweite Tabelle wird entsprechend der zu erwartenden Gain-Änderung vorab berechnet. Bei Umschaltung der VGA Verstärkung wird dann gleichzeitig auf die neue Tabelle für die Vorverzerrung zugegriffen.

Insgesamt wird also durch die Erfindung, ein Verfahren und eine Schaltungsanordnung zur Linearisierung einer Kennlinie eines Leistungsverstärkers in Mobilfunktelefonen, vorzugsweise eines UMTS-Leistungsverstärkers, vorgestellt, bei dem/der nichtlineare Verzerrungen reduziert werden können. Außerdem tritt die bisher beim Signalvergleich auftretende Zeitverzögerung im Bereich von wenigen Nanosekunden nun nicht mehr auf.

Es versteht sich, dass die vorstehend genannten Merkmale der Erfindung nicht nur in der jeweils angegebenen Kombination, sondern auch in anderen Kombinationen oder in Alleinstellung verwendbar sind, ohne den Rahmen der Erfindung zu verlassen, wobei der Schutzumfang alleine durch die Ansprüche definiert wird.

Auflistung der verwendeten Abkürzungen:

ACLR Adjacent Channel Leakage Ratio
AM Amplitudenmodulation
EDGE Enhanced Data Service for GSM Evolution
GSM Global System for Mobile Communications (Mobilfunk)
HPSK Hybrid Phase Shift Keying
LUT Look-Up-Tabelle
PA Power Amplifier = Leistungsverstärker
$P_{in}$ Eingangsleistung
PM Phasenmodulation
$P_{out}$ Ausgangsleistung
PSK Phase Shift Keying = Phasenumtastung bei der Modulation
RRC Root Riased Cosine
UMTS Universal Mobile Telecommunications System
VGA Variable Gain Amplifier = Vorverstärker
WCDMA Wideband Code Division Multiplex Access

Bezugszeichenliste

| | |
|---|---|
| 1 | Signal V |
| 2 | Vorverzerrer mit Charakteristik G(V) |
| 3 | Leistungsverstärker PA mit Kennlinie H(x) |
| 4 | Signal V, um den Faktor k verstärkt |
| 5 | Basisband |
| 6 | Signal $V_m(t)$ aus dem Basisband |
| 7 | Komplexer Multiplizierer |
| 8 | Digital/Analog Wandler |
| 9 | Signal $V_d(t)$ vor der Modulation |
| 10 | Modulator |
| 11 | Leistungsverstärker |
| 11.1 | Signaleingang des Leistungsverstärkers |
| 11.2 | Signalausgang des Leistungsverstärkers |
| 12 | Sendesignal $V_a(t)$ des Leistungsverstärkers |
| 13 | Koppler |
| 14 | Demodulator |
| 15 | Local Oszilator |
| 16 | Analog/Digital Wandler |
| 17 | Ausgangssignal $V_f(t)$ nach Demodulation und Quantisierung |
| 18 | Vergleichereinheit |
| 19 | Differenzsignal $V_e(t)$ |
| 20 | Aktualisierung und Anpassung der Algorithmen |
| 21 | Look-Up-Tabelle |
| 22 | Eingangsamplitude des Signals $V_m(t)$ = Betrag des Signals im Quadrat = $|V_m(t)|^2$ |
| 23 | Zeitverzögerung $\tau_D$ |
| 24 | Vorverzerrereinheit/Predistorer |
| 25 | Mischer |
| 26 | Vorverstärker Variable Gain Amplifier VGA |
| 27 | Ausgangssignal $V_{reg}(t)$ nach Quantisierung, Demodulation und Faltung |
| 28 | Ausgangssignal $V_{ab}(t)$ nach der Quantisierung |
| 29 | Sendefilter |
| 30 | Parameter Extraktion |
| 31 | Berechnung der Look-Up-Tabelle |
| 32 | Empfänger |
| 33 | Verzweiger |

**Patentansprüche**

1. Verfahren zur Linearisierung eines Leistungsverstärkers (11) in Mobilfunktelefonen, vorzugsweise eines UMTS-Leistungsverstärkers, bei dem amplituden- und phasenmodulierte Signale (6) eines digitalen Basisbandes (5) vorverzerrt (Digitale Basisband Predistortion), anschließend am Eingang (11.1) des nichtlinearen Leistungsverstärkers (11) eingespeist und als verstärkte Signale (12) am Ausgang (11.2) des Leistungsverstärkers (11) ausgekoppelt und abgetastet werden, wobei durch einen Signalvergleich Vorverzerrungsfaktoren bestimmt werden,
**dadurch gekennzeichnet,**
**dass** zum Signalvergleich die am Ausgang (11.2) anliegenden Signale (12) durch einen Koppler (13) ausgekoppelt, abgetastet und in zwei Teile (27 und 28) verzweigt werden, wobei in einem ersten Teil (27) die Signale (6) des Basisbandes (5) regeneriert werden, ein zweiter Teil (28) unverändert bleibt und der erste Teil (27) mit dem zweiten Teil (28) verglichen wird.

2. Verfahren gemäß dem voranstehenden Patenanspruch 1,
**dadurch gekennzeichnet,**
**dass** zur Signalregenerierung der erste Teil (27) demoduliert und gefaltet wird.

**3.** Verfahren gemäß einem der voranstehenden Patenansprüche 1 und 2,
**dadurch gekennzeichnet,**
**dass** die Kennlinie des Leistungsverstärkers (11) in Bezug auf AM/AM- und AM/PM-Konversion durch Polynome modelliert wird und in Abhängigkeit des Signalvergleiches die Koeffizienten der Polynome errechnet werden.

**4.** Verfahren gemäß einem der voranstehenden Patenansprüche 1 bis 3,
**dadurch gekennzeichnet,**
**dass** die Vorverzerrungsfaktoren aus den Polynomen mit den Polynomkoeffizienten errechnet werden.

**5.** Verfahren gemäß einem der voranstehenden Patenansprüche 1 bis 4,
**dadurch gekennzeichnet,**
**dass** die Vorverzerrungsfaktoren in einer Look-Up-Tabelle (21) hinterlegt werden.

**6.** Schaltungsanordnung zur Linearisierung eines Leistungsverstärkers (11) in Mobilfunktelefonen, vorzugsweise eines UMTS-Leistungsverstärkers, mindestens bestehend aus: einem Leistungsverstärker (11), an dessen Signaleingang (11.1) phasen- und amplitudenmodulierte Signale (6) eines Basisbandes (5) mit einer Vorverzerrereinheit (24) eingespeist werden, die am Signalausgang (11.2) als verstärkte Signale (12) für einen Empfänger (32) ausgeben werden und einem Koppler (13), der die Signale (12) am Signalausgang (11.2) auskoppelt und mit einem Analog/Digital-Wandler (16) abtastet, wobei durch einen Signalvergleich Vorverzerrungsfaktoren bestimmt werden,
**dadurch gekennzeichnet,**
**dass** zum Signalvergleich am Ausgang (11.2) ein Koppler (13) angeordnet ist, der die Signale (12) auskoppelt und abtastet, ein Verzweiger (33) angeordnet ist, der die Signale in zwei Teile (27 und 28) verzweigt,
wobei im Pfad des ersten Teils (27) Mittel zur Regenerierung der Signale (6) des Basisbandes (5) angeordnet sind und der Pfad des zweiten Teils (28) frei von Mitteln zur Veränderung des Signals vorliegt,
und Mittel (30) angeordnet sind, die den ersten Teil (27) mit dem zweiten Teil (28) vergleichen.

**7.** Schaltungsanordnung gemäß dem voranstehenden Patenanspruch 6,
**dadurch gekennzeichnet,**
**dass** zur Signalregenerierung ein Demodulator (14) und ein Filter (29) angeordnet sind.

**8.** Schaltungsanordnung gemäß einem der voranstehenden Patenansprüche 6 und 7,
**dadurch gekennzeichnet,**
**dass** Mittel (30) angeordnet sind, die die Kennlinie des Leistungsverstärkers (11) in Bezug auf dessen AM/AM-und AM/PM-Charakteristik durch Polynome modellieren.

**9.** Schaltungsanordnung gemäß einem der voranstehenden Patenansprüche 6 bis 8,
**dadurch gekennzeichnet,**
**dass** Mittel (31) angeordnet sind, die die Vorverzerrungsfaktoren aus den Polynomen mit den Polynomkoeffizienten errechnen.

**10.** Schaltungsanordnung gemäß einem voranstehenden Patenansprüche 6 bis 9,
**dadurch gekennzeichnet,**
**dass** eine Look-Up-Tabelle (21) angeordnet ist, in der die Vorverszerrungsfaktoren hinterlegt werden.

**Claims**

**1.** Method for linearization of a power amplifier (11) in mobile phones, preferably a UMTS power amplifier, in which amplitude-modulated and phase-modulated signals (6) of a digital baseband signal (5) are predistorted (Digital Baseband Predistortion), are then injected at the input (11.1) of the non-linear power amplifier (11) and are coupled out and sampled as amplified signals (12) at the output (11.2) of the power amplifier (11), whereby predistortion factors are defined by means of a signal comparison,
**characterized in that**
the signals (12) present at the output (11.2) are coupled out by a coupler (13), sampled and branched into two parts (27 and 28) for the signal comparison, whereby, in a first part (27), the signals (6) of the baseband (5) are regenerated, a second part (28) remains unchanged, and the first part (27) is compared with the second part (28).

**2.** Method according to the previous Claim 1,

**characterized in that**
the first part (27) is demodulated and folded for the signal regeneration.

3. Method according to one of the preceding Claims 1 and 2,
   **characterized in that**
   the characteristic of the power amplifier (11) is modelled by polynomials with reference to AM/AM and AM/PM conversion, and the coefficients of the polynomials are calculated depending on the signal comparison.

4. Method according to one of the preceding Claims 1 to 3,
   **characterized in that**
   the predistortion factors are calculated from the polynomials with the polynomial coefficients.

5. Method according to one of the preceding Claims 1 to 4,
   **characterized in that**
   the predistortion factors are stored in a look-up table (21).

6. Apparatus for linearization of a power amplifier (11) in mobile phones, preferably a UMTS power amplifier, comprising at least a power amplifier (11), at the signal input (11.1) of which phase-modulated and amplitude-modulated signals (6) of a baseband (5) are injected with a predistorter unit (24) and are output at the signal output (11.2) as amplified signals (12) for a receiver (32), and a coupler (13), which couples out the signals (12) at the signal output (11.2) and samples them with an analogue/digital converter (16), whereby predistortion factors are defined by means of a signal comparison,
   **characterized in that**,
   for the signal comparison, a coupler (13) is disposed at the output (11.2) which couples out and samples the signals (12), a branching element (33) is disposed which branches the signals into two parts (27 and 28), whereby means for regenerating the signals (6) of the baseband (5) are disposed in the path of the first part (27), and the path of the second part (28) remains free of means to change the signal,
   and means (30) are disposed which compare the first part (27) with the second part (28).

7. Apparatus according to the above Claim 6,
   **characterized in that**
   a demodulator (14) and a filter (29) are disposed for signal regeneration.

8. Apparatus according to one of the preceding Claims 6 and 7,
   **characterized in that**
   means (30) are disposed which model the characteristic of the power amplifier (11) with reference to its AM/AM and AM/PM characteristic by means of polynomials.

9. Apparatus according to one of the preceding Claims 6 to 8,
   **characterized in that**
   means (31) are disposed which calculate the predistortion factors from the polynomials with the polynomial coefficients.

10. Apparatus according to one of the preceding Claims 6 to 9,
    **characterized in that**
    a look-up table (21) is disposed in which the predistortion factors are stored.

**Revendications**

1. Procédé de linéarisation d'un amplificateur de puissance (11) dans des téléphones de radiocommunication mobile, de préférence d'un amplificateur de puissance UMTS, dans lequel des signaux (6) modulés en amplitude et en phase d'une bande de base numérique (5) sont prédistordus (prédistorsion de bande de base numérique), sont ensuite alimentés à l'entrée (11.1) de l'amplificateur de puissance (11) non linéaire et découplés à la sortie (11.2) de l'amplificateur de puissance (11) comme signaux amplifiés (12), et sont explorés, des facteurs de prédistorsion étant déterminés au moyen d'une comparaison de signaux,
   **caractérisé en ce**
   **que** les signaux (12) présents à la sortie (11.2) sont découplés par un coupleur (13) pour la comparaison de signaux, explorés et divisés en deux parties (27 et 28), dans une première partie (27) les signaux (6) de la bande de base (5) étant régénérés et une deuxième partie (28) restant inchangée, et la première partie (27) étant comparée à la deuxième partie (28).

2. Procédé selon la revendication précédente 1,
   **caractérisé en ce**
   **que** la première partie (27) est démodulée et soumise à une convolution pour régénérer les signaux.

3. Procédé selon l'une des revendications précédentes 1 et 2,
   **caractérisé en ce**
   **que** la caractéristique de l'amplificateur de puissance (11) est modelée au moyen de polynômes en ce qui concerne la conversion AM/AM et AM/PM et en ce que les coefficients des polynômes sont calculés en fonction de la comparaison des signaux.

4. Procédé selon l'une des revendications précédentes 1 à 3,
   **caractérisé en ce**
   **que** les facteurs de prédistorsion sont calculés à partir des polynômes au moyen des coefficients de polynôme.

5. Procédé selon l'une des revendications précédentes 1 à 4,
   **caractérisé en ce**
   **que** les facteurs de prédistorsion sont mémorisés dans une table Look-Up (21).

6. Dispositif de circuit pour la linéarisation d'un amplificateur de puissance (11) dans des téléphones de radiocommunication mobile, de préférence d'un amplificateur de puissance UMTS, au moins constitué des éléments suivants : d'un amplificateur de puissance (11), à l'entrée de signal (11.1) duquel des signaux (6) modulés en phase et en amplitude d'une bande de base (5) sont alimentés au moyen d'une unité de prédistorsion (24), qui sont sortis à la sortie de signal (11.2) comme signaux amplifiés (12) pour un récepteur (32), et d'un coupleur (13) qui découple les signaux (12) à la sortie de signal (11.2) et les explore au moyen d'un convertisseur analogique-numérique (16), des facteurs de prédistorsion étant déterminés au moyen d'une comparaison de signaux,
   **caractérisé en ce**
   **que** pour la comparaison de signaux, un coupleur (13) est disposé à la sortie (11.2), ce coupleur découplant et explorant les signaux (12), un dispositif de bifurcation (33) est disposé, qui divise les signaux en deux parties (27 et 28), des moyens pour régénérer les signaux (6) de la bande de base (5) étant disposés dans le chemin de la première partie (27) et le chemin de la deuxième partie (28) étant exempt de moyens pour modifier le signal, et des moyens (30) étant disposés, qui comparent la première partie (27) à la deuxième partie (28).

7. Dispositif de circuit selon la revendication précédente 6,
   **caractérisé en ce**
   **qu'**un démodulateur (14) et un filtre (29) sont disposés pour régénérer les signaux.

8. Dispositif de circuit selon l'une des revendications précédentes 6 et 7,
   **caractérisé en ce**
   **que** des moyens (30) sont disposés, qui modèlent la caractéristique de l'amplificateur de puissance (11) au moyen de polynômes en ce qui concerne sa caractéristique AM/AM et AM/PM.

9. Dispositif de circuit selon l'une des revendications précédentes 6 à 8,
   **caractérisé en ce**
   **que** des moyens (31) sont disposés, qui calculent les facteurs de prédistorsion à partir des polynômes au moyen des coefficients des polynômes.

10. Dispositif de circuit selon l'une des revendications précédentes 6 à 9,
    **caractérisé en ce**
    **qu'**une table Look-Up (21) est disposée, dans laquelle sont mémorisés les facteurs de prédistorsion.

## FIG 1

Stand der Technik

P out vs P in

1920 MHz ; 3.0 V

## FIG 2

Stand der Technik

AM-AM-Konversion

# FIG 3

Stand der Technik

AM-AM-Konversion

# FIG 4

Stand der Technik

## FIG 5

Stand der Technik

## FIG 6